**Europäisches Patentamt**

**European Patent Office**

**Office européen des brevets**

(11) Publication number : **0 393 027 B1**

# EUROPEAN PATENT SPECIFICATION

(45) Date of publication of patent specification :
**13.05.92 Bulletin 92/20**

(21) Application number : **88900970.0**

(22) Date of filing : **10.12.87**

(86) International application number :
**PCT/US87/03277**

(87) International publication number :
**WO 88/09034 17.11.88 Gazette 88/25**

(51) Int. Cl.⁵ : **G11C 7/06**

(54) SENSE AMPLIFIER.

(30) Priority : **15.05.87 US 51085**

(43) Date of publication of application :
**24.10.90 Bulletin 90/43**

(45) Publication of the grant of the patent :
**13.05.92 Bulletin 92/20**

(84) Designated Contracting States :
**AT BE CH DE FR GB IT LI LU NL SE**

(56) References cited :
**Patent Abstracts of Japan, volume 7, no. 150 (P-207)(1295), 30 June 1983,**
**Patent Abstracts of Japan, volume 5, no. 165 (P-85)(837),22 October1981,**

(73) Proprietor : **ANALOG DEVICES, INCORPORATED**
**Route 1 Industrial Park**
**Norwood, MA 02062 (US)**

(72) Inventor : **GARDE, Douglas**
**35A Hartford Street**
**Dover, MA 02030 (US)**

(74) Representative : **Warren, Anthony Robert et al**
**BARON & WARREN 18 South End Kensington**
**London W8 5BU (GB)**

## Description

This invention relates to the field of memory devices for digital computers and, more specifically, to a sense amplifier for a random access read/write memory (RAM) cell fabricated using metal oxide semiconductor (MOS) components.

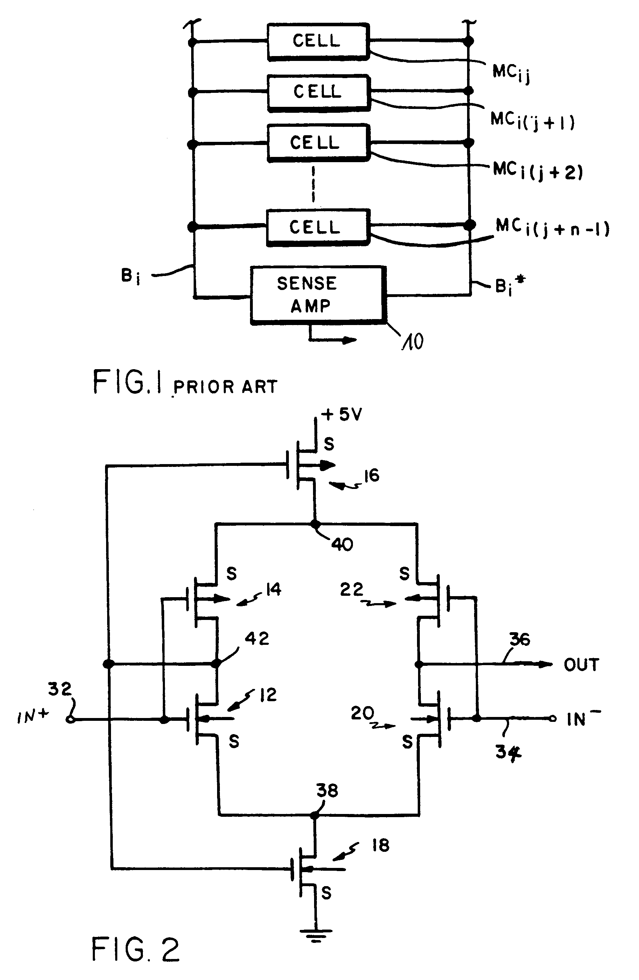

Random access read/write memory devices are generally assembled from a matrix or other grouping of memory cells. Each such cell is capable of storing one binary digit, or bit, of information. A conventional prior art RAM device has the form generally illustrated in Fig. 1, wherein each memory cell $MC_{xy}$ (where x and y are indices in a two-dimensional matrix) is connected to a pair of conductors $B_x$ and $B^*_x$. The conductors $B_x$ and $B^*_x$ are typically called bit lines, bit-sense lines, or bit buses. In the Figure, a portion of a column of the matrix is shown for the value x=i, from rows y=j through y=j+n-1. Bit lines $B_x$ and $B^*_x$ normally carry signals of complementary values imposed by a differential output stage in, for example, a write amplifier of memory cell. For reading the contents of a cell, a differential voltage representing those contents is provided via bit lines $B_x$ and $B^*_x$ to a sense amplifier 10. The conventional sense amplifier typically has a differential input stage to receive the signals imposed on the bit lines and a double-ended (i.e., differential) output for driving subsequent amplifier stages.

Sense amplifier design has a substantial impact on the performance of a RAM. The two most important characteristics of a RAM influenced by its sense amplifiers are the speed of the read operation and the power consumption of the device. Often, these two factors work against each other; more power is frequently required when faster switching speed is desired of an amplifier. A good sense amplifier, though, should switch states rapidly, draw little power, be reliable and be inexpensive to produce.

Noise immunity is also very much dependent on sense amplifier design. A sense amplifier should be minimally sensitive to power supply fluctuations and to common mode signals appearing on the bi: lines, while being maximally sensitive to differential signals appearing on those same conductors.

Minimisation of sense amplifier power consumption during quiescent conditions is particularly important. At any instant, a typical RAM chip or array of chips will usually have very few sense amplifiers engaged in switching compared to the number of sense amplifiers sitting idly under quiescent conditions. Therefore, if the RAM chip is to dissipate only a small amount of power, quiescent current drain by the sense amplifiers must be minimized.

Many designs have been proposed for MOS sense amplifiers and many techniques have been advocated for providing faster, lower-power-consumption sense amplifiers. Among these techniques are bit line equalization (pre-charging) and address transition detection. The prior art also includes sense amplifiers using complementary MOSFET devices on both sides of a differential amplifier, with gate inputs configured to effect voltage swing without providing a high conductance current path and the use of shunt-connected devices driven by complementary outputs in place of active load resistances, to improve common mode rejection. Further, the art includes the use of a number of feedback arrangements to improve switching speed and other characteristics.

These various improvements are achieved in the prior art at the expense of increasing the number of components in each sense amplifier, generally with an attendant increase in the area of the semiconductor required for each sense amplifier and, possibly, consumption of unnecessary power.

For example, the Patent Abstracts of Japan, Vol. 7, No. 150, 30 June 1983, page 90 P 207, publication 58- 60486(A) (referring to Japanese Pat. Apl. No. 56- 157506) shows a five-MOSFET sense amplifier which is similar to the present invention but only reduces power consumption for one state of the input signals.

Therefore, it is an object of the present invention to provide an improved sense amplifier.

Another object of the present invention is to provide a sense amplifier which is capable of reducing power dissipation for all input signals and still providing high speed operation.

The present invention provides a sense amplifier as indicated in claim 1.

The sense amplifier embodying the invention has a differential input but only a single-ended output. This sense amplifier is formed of only six MOS transistors but has excellent common mode rejection properties, fast switching characteristics and excellent common mode rejection.

In an exemplary embodiment, the non-inverting input is connected to the gates of a first MOSFET and a second MOSFET. The drains of the first and second MOSFETs are connected to each other and to the gates of third and fourth MOSFETs. The drain of the third MOSFET is connected to the sources of the second and sixth MOSFETs; and the source of the third MOSFET is connected to the positive supply voltage. The drain of the fourth MOSFET is connected to the sources of the first and fifth MOSFETs. The source of the fourth MOSFET is connected to ground. The inverting input of the sense amplifier is connected to the gates of the fifth and sixth MOSFETs. The drains of the fifth and sixth MOSFETs are connected to each other and provide the output terminus of the amplifier. The first, fourth and fifth MOSFETs are n-channel devices, while the second, third and sixth MOSFETs are p-channel devices.

The sense amplifier thus has the desirable property of being formed entirely from MOS devices. Further, it has no pull-up resistance: (either active or passive).

In order that the invention may be more readily understood, reference will now be made to the accompanying drawing, in which:-

Fig. 1 is a block diagram of a prior art RAM illustrating the general architecture of such devices; and

Fig. 2 is a schematic circuit diagram of one embodiment of the present invention for use in a MOS RAM device such as that shown in Fig. 1.

Fig. 2 shows a sense amplifier 10 embodying the present invention. Amplifier 10 is formed from six metal oxide semiconductor field effect transistors (MOSFETs) 12 - 22. It has a non-inverting input 32 for receiving a non-inverting input signal represented by the label IN$^+$ and an inverting input 34 for receiving an inverting input signal represented by the label IN$^-$. The output of the amplifier appears on the lead 36, labeled OUT.

The non-inverting input 32 is connected to the gates of first MOSFET 12 and second MOSFET 14. The drain of the first MOSFET 12 and the drain of the second MOSFET 14 are connected to each other and to the gates of third and fourth MOSFETs 16 and 18. The drain of the third MOSFET 16 is connected to the source of the second MOSFET 14 and the source of the third MOSFET 16 is connected to the positive supply voltage. The drain of the fourth MOSFET 18 is connected to the source of the first MOSFET 12 and the source of the fourth MOSFET 18 is connected to ground.

The inverting input 34 of the sense amplifier is connected to the gates of fifth and sixth MOSFETs 20 and 22. The drain of the fifth MOSFET 20 and the drain of the sixth MOSFET 26 are connected to each other and provide the output terminal or lead 36 of the amplifier. Further, the source of the fifth MOSFET 20 is connected to the juncture 38 of the first MOSFET's source and the fourth MOSFET's drain. Also, the source of the sixth MOSFET 22 is connected to the juncture 40 of the second MOSFET's source and the third MOSFET's drain. The first, fourth and fifth MOSFETs are n-channel devices, while the second, third and sixth MOSFETs are p-channel devices.

In the steady state, when the non-inverting input 32 is high and the inverting input 34 is low, transistor 12 is turned on and transistor 14 is turned off. Since the inverting input 34 is low at this time, transistor 22 is turned on. The combination of these conditions turns transistor 16 on, turns transistor 18 off and pulls the output lead 36 high.

Conversely, when the inverting input 34 is high and the non-inverting input 32 is low, transistors 20 and 14 are turned on and transistors 22 and 12 are turned off. The combination of these conditions turns on transistor 18, turns off transistor 16 and pulls the output lead 36 low.

At node 42, the voltage swings (with state changes) from a low of about 1.5 volts to a high of about 3.5 volts; but the output lead approaches, to within a few tenths of volts, zero volts at one extreme and five volts at the other extreme. That is, the gain in the circuit produces a limiting and stabilizing effect at node 42. Excellent common mode rejection is obtained from the fact that one of transistors 12 and 14 is off at all times and one of transistors 20 and 22 is off at all times. Quiescent current drain is very low since one of transistors 16 and 18 is always off during quiescent operation; thus, there is only a very high impedance path between the power supply and ground.

## Claims

1. A sense amplifier having non-inverting and inverting inputs for connection, respectively, to first and second bits lines which, in turn, communicate with at least one MOS memory cell, and also having an output, such amplifier comprising (a) first through fifth MOS transistors (12, 14, 18, 20, 22), each having source, drain and gate electrodes, the first (12), third (18) and fourth (20) MOS transistors being of a first channel type, the second (14) and the fifth (22) MOS transistors being of the second channel type; (b) the non-inverting input (IN+) being connected to the gate electrodes of the first and second MOS transistors (12 and 14); (c) the drain electrodes of the first (12) and second (14) MOS transistors being connected to each other and to the gate electrode of the third MOS transistor (18); (d) the source electrodes of the first (12) and fourth (20) MOS transistors being connected to each other, and to the drain electrode of the third MOS transistor (18); (e) the source electrode of the third MOS transistor (18) being connected to ground; (f) the inverting input (IN-) being connected to the gates of the fourth (20) and fifth (22) MOS transistors; (g) the drain electrodes of the fourth and fifth MOS transistors (20 and 22) being connected to each other and to the sense amplifier output (OUT); characterised by: (h) a sixth MOS transistor (16), being of the second channel type, also having source, drain and gate electrodes; (i) the drain electrode of the sixth MOS transistor (16) being connected to the source electrodes of the second and fifth transistors (14 and 22); (j) the gate electrode of the sixth MOS transistor (16) being connected to the drains of the first and second MOS transistors (12 and 14) and the gate of the third MOS transistor (18); and (k) the source electrode of the sixth MOS transistor (16), in operation, being connected to the supply voltage.

## Patentansprüche

1. Ein Leseverstärker mit nicht invertierenden und invertierenden Eingängen zum Anschluß an erste und zweite Bitleitungen, die wiederum mit mindestens einer MOS-Speicherzelle kommunizieren, und außerdem mit einem Ausgang, wobei der Verstärker (a) erste bis fünfte MOS-Transistoren (12, 14, 18, 20, 22) aufweist, die jeweils Quellen-, Senken- und Torelektroden aufweisen, und wobei der erste (12), dritte (18) und vierte (20) MOS-Transistor eine erste Kanalart haben, während der zweite (14) und fünfte (22) MOS-Transistor die zweite Art Kanal aufweisen; (b) der nicht invertierende Eingang (IN+) ist an die Torelektroden des ersten und zweiten MOS-Transistors (12 und 14) angeschlossen; (c) die Senkenelektroden des ersten (12) und zweiten (14) MOS-Transistors sind miteinander und mit der Torelektrode des dritten MOS-Transistors (18) verbunden; (d) die Quellenelektroden des ersten (12) und vierten (20) MOS-Transistors sind miteinander und mit der Senkenelektrode des dritten MOS-Transistors (18) verbunden; (e) die Quellenelektrode des dritten MOS-Transistors (18) ist mit Erde verbunden; (f) der invertierende Eingang (IN-) ist mit den Toren des vierten (20) und fünften (22) MOS-Transistors verbunden; (g) die Senkenelektroden des vierten und fünften MOS-Transistors (20 und 22) sind miteinander und mit dem Leseverstärkerausgang (OUT) verbunden; gekennzeichnet durch folgende Merkmale: (h) ein sechster MOS-Transistor (16) mit der zweiten Kanalart hat ebenfalls Quellen-, Senken- und Torelektroden; (i) die Senkenelektrode des sechsten MOS-Transistors (16) ist mit den Quellenelektroden des zweiten und fünften Transistors (14 und 22) verbunden; (j) die Torelektrode des sechsten MOS -Transistors (16) ist mit den Senken des ersten und zweiten MOS-Transistors (12 und 14) und mit dem Tor des dritten MOS-Transistors (18) verbunden; und (k) die Quellenelektrode des sechsten MOS-Transistors (16) ist im Betrieb an die Versorgungsspannung angeschlossen.

## Revendications

1. Amplificateur de lecture ayant des entrées non inverseuses et inverseuses adaptées à se connecter respectivement à des première et seconde lignes de bits qui, à leur tour, communiquent avec au moins une cellule de mémoire MOS, ledit amplificateur ayant aussi une sortie ; ledit amplificateur comprenant : a) des premier à cinquième transistors MOS (12, 14, 18, 20, 22), ayant chacun des électrodes d'émetteur, de collecteur et de base, les premier (12), troisième (18) et quatrième (20) transistors MOS étant d'un premier type de canal, les second (14) et cinquième (22) transistor MOS étant du second type de canal ; b) l'entrée non inverseuse (IN+) étant connectée aux électrodes de base des premier et second transistors MOS (12, 14) ; c) les électrodes de collecteur des premier (12) et second (14) transistors MOS étant connectées ensemble et à l'électrode de base du troisième transistor MOS (18) ; d) les électrodes d'émetteur des premier (12) et quatrième (20) transistor MOS étant connectées ensemble et à l'électrode de collecteur du troisième transistor MOS (18) ; e) l'électrode d'émetteur du troisième transistor MOS (18) étant connectée à la terre ; f) l'entrée inverseuse (IN-) étant connectée aux bases des quatrième (20) et cinquième (22) transistors MOS ; g) les électrodes de collecteur des quatrième et cinquième transistors MOS (20 et 22) étant connectées ensemble et la sortie de l'amplificateur de lecture (OUT) ; caractérisé par : h) un sixième transistors MOS (16), qui est du second type de canal, ayant aussi des électrodes d'émetteur de collecteur et de base ; i) l'électrode de collecteur de sixième transistor MOS (16) étant connectée aux électrodes d'émetteur des second et cinquième transistor (14 et 22) ; j) l'électrode de base du sixième transistor MOS (16) étant connectée au collecteur des premier et second transistor MOS (12 et 14) et à la base du troisième transistor MOS (18) ; et k) l'électrode d'émetteur du sixième transistor MOS (16), en fonctionnement, étant connectée à l'alimentation de tension.

FIG.1 PRIOR ART

FIG. 2